# EUROPÄISCHE PATENTSCHRIFT

(11) **EP 3 545 279 B1**
(45) Veröffentlichungstag und Bekanntmachung des Hinweises auf die Patenterteilung: **30.09.2020**
(21) Anmeldenummer: 17811239.7
(22) Anmeldetag: 24.11.2017
(51) Int. Cl.: G01M 13/026, F16F 15/00, G01M 15/12, B60W 30/20, B60W 50/00, G01L 3/02

(54) **VERFAHREN UND VORRICHTUNG ZUR REGELUNG EINER PRÜFSTANDSANORDNUNG**
METHOD AND DEVICE FOR CONTROLLING A TEST STAND ARRANGEMENT
PROCÉDÉ ET DISPOSITIF DE RÉGULATION D'UNE INSTALLATION DE BANC D'ESSAI

(30) Priorität: 28.11.2016 AT 510762016
(43) Veröffentlichungstag der Anmeldung: 02.10.2019
(73) Patentinhaber: AVL List GmbH, 8020 Graz (AT)
(72) Erfinder: KOKAL, Helmut, 8020 Graz (AT)
(74) Vertreter: Patentanwälte Pinter & Weiss OG
(86) Internationale Anmeldenummer: PCT/EP2017/080315
(87) Internationale Veröffentlichungsnummer: WO 2018/096085

(56) Entgegenhaltungen:
- EP-A1- 0 280 948
- US-A1- 2011 238 359
- KOKAL H ET AL: "Bandwidth extension of dynamical test benches by modified mechanical design under adaptive feedforward disturbance rejection", AMERICAN CONTROL CONFERENCE (ACC), 2010, IEEE, PISCATAWAY, NJ, USA, 30. Juni 2010 (2010-06-30), Seiten 6151-6156, XP031719998, ISBN: 978-1-4244-7426-4

## Beschreibung

Die Erfindung betrifft ein Verfahren und eine Vorrichtung zur Regelung einer Prüfstandsanordnung mit einem Prüfling und mit einer Belastungsmaschine, die durch eine Verbindungswelle mit dem Prüfling verbunden ist.

Bei Motorenprüfständen in überkritischer Anordnung kommt es häufig zur Anregung der Prüfstandseigenfrequenz durch noch nicht gut abgestimmte Verbrennungsprozesse in den einzelnen Zylindern eines Verbrennungsmotors (speziell bei Motoren, die noch in einem Entwicklungsstadium sind). Dies kann sich dann beispielsweise durch auftreten der 0,5-ten Ordnung im Momentenverlauf äußern, welche dann die Prüfstandseigenfrequenz anregen kann. Diese Resonanz hat als Konsequenz einen unnatürlichen Drehzahlverlauf des Verbrennungsmotors. Solche Effekte erschweren eine saubere Kalibrierung am Verbrennungsmotor bzw. kann sich eine Kalibrierung als unmöglich erweisen, beispielsweise bei einer Zündaussetzererkennung.

Dabei besteht unter anderem das Problem, dass die derart verursachten Störungen nicht direkt messbar und somit einer Regelung entzogen sind.

Es ist das Ziel der gegenständlichen Erfindung, Verfahren und Vorrichtungen zur Prüfstandregelung vorzusehen, mit denen derartige Effekte stark reduziert werden können. WO2011/022746 beschreibt ein Regelungsverfahren für eine Prüfstandsanordnung, wobei zur Erhöhung der Regelgüte anhand einer Auswertung des Drehwinkels das innere Drehmoment des Verbrennungsmotors ermittelt und mithilfe eines Repetitive-Control-Verfahrens im Regelkreis rückgeführt wird. Eine Bedämpfung von Eigenfrequenzen der Prüfstandsanordnung sieht die Offenbarung der WO2011/022746 nicht vor. Andere Beispiele sind in den Dokumenten KOKAL H ET AL: "Bandwidth extension of dynamical test benches by modified mechanical design under adaptive feedforward disturbance rejection", AMERICAN CONTROL CONFERENCE (ACC), 2010, IEEE, PISCATAWAY, NJ, USA, 30 June 2010 (2010-06-30), pages 6151 - 6156, US2011/238359 und EP0280948 beschrieben.

In realen Prüfstandsumgebungen ist es oftmals nicht möglich, bestimmte Messgrößen, wie etwa den Drehwinkel, mit einer ausreichenden Genauigkeit zu Messen. Entweder gibt es im Stand der Technik keine dazu erforderliche Sensoren oder der hohe Aufwand, den die Installation und die Verwendung bekannter Sensoren mit sich bringen würde, verunmöglicht einen Einsatz. Es ist daher ein Ziel der gegenständlichen Anmeldung, eine Bedämpfung von Eigenschwingungen mithilfe der im Prüfstand üblicherweise vorhandenen Sensorik zu ermöglichen.

Erfindungsgemäß werden die Ziele der gegenständlichen Anmeldung durch ein Verfahren der eingangs genannten Art gemäß Anspruch 1 gelöst, bei dem ein Schätzwert für das innere Drehmoment des Prüflings ermittelt wird, wobei aus dem Schätzwert unter Berücksichtigung einer zu dämpfenden Eigenfrequenz und einer Verzögerung ein Bedämpfungssignal ermittelt und im Regelkreis rückgeführt wird. Das rückgeführte Bedämpfungssignal kann gegebenenfalls mithilfe einer vorzugsweise einstellbaren Verstärkung auf eine vorteilhafte Signalstärke eingestellt werden. Somit können vom Prüfling kommende und an sich nicht messbare Störungen geschätzt und für die Bedämpfung berücksichtigt werden. Dabei wird die eigentliche Störgröße (im Fall eines Verbrennungsmotorprüfstands ist das das innere Verbrennungsmoment) in Form eines Schätzwerts als Eingang in die Regelung verwendet. Bei vergleichbaren Vorrichtungen war es bisher bekannt, eine gemessene Größe (z.B. ein Messflanschdrehmoment, eine Prüflingsdrehzahl, eine Belastungseinheits-Drehzahl, etc.) als Reglereingang zu verwenden. Oftmals enthalten diese Messgrößen jedoch bereits die Auswirkungen der von der Störung angeregten Eigenfrequenz und sind als Reglereingang nicht gut geeignet.

In vorteilhafter Weise kann der Schätzwert aus der Prüflingswinkelgeschwindigkeit und dem Wellenmoment ermittelt werden. Dies erleichtert die Ermittlung der Eingangswerte, da die üblicherweise im Prüfstand vorhandenen Sensoren verwendet werden können.

In einer vorteilhaften Ausführungsform kann bei der Ermittlung des Bedämpfungssignals aus dem Schätzwert ein die zu dämpfende Eigenfrequenz umfassender Bandbereich herausgefiltert und das herausgefilterte Signal um eine Verzögerung verzögert und um eine Verstärkung verstärkt werden. Somit kann aufgrund der Periodizität der Störung eine phasenrichtige Aufschaltung der Dämpfungsenergie auf die Belastungseinheit rückgeführt werden.

In vorteilhafter Weise können die Parameter für die Verzögerung und/oder die Verstärkung und/oder den Bandbereich in einer Simulation vorab bestimmt werden. Dies verkürzt die für den Prüflauf erforderliche Prüfstandzeit und verhindert eine zeitraubende Parametrisierung durch Versuch und Irrtum.

In einer bevorzugten Ausführungsform kann die Verzögerung ein konstanter Parameter sein. Dies erlaubt eine besonders einfache Implementierung, etwa unter Verwendung eines mit einer konstanten Verzögerung parametrisierten FIFO-Speichers. Die Phasenvordrehung der Störgröße erfolgt dabei unter Ausnutzung von Periodizität der Störgröße und konstanter Eigenfrequenz der Prüfstandsanordnung. Die Verzögerung kann dabei optimal an die Systemperformance des Regelkreises angepasst werden.

Zur Vorteilhaften Umsetzung des obigen Verfahrens weist die eingangs genannte Vorrichtung gemäß Anspruch 6 eine Bedämpfungseinheit mit einer Schätzeinheit und einem Filter auf, wobei die Schätzeinheit einen Schätzwert für das innere Drehmoment des Prüflings erstellt und wobei der Filter aus dem Schätzwert auf Basis einer zu dämpfenden Eigenfrequenz und einer Verzögerung ein Bedämpfungssignal erstellt und im Regelkreis rückführt.

In vorteilhafter Weise kann die Schätzeinheit den Schätzwert aus der Prüflingswinkelgeschwindigkeit und dem Wellenmoment ermitteln. Dies erlaubt die Erstellung eines Schätzwerts ohne zusätzliche Sensorik.

In einer bevorzugten Ausführungsform kann die Schätzeinheit einen Kalman-Filter aufweisen, was eine einfache und schnelle Erzeugung des Schätzwerts erlaubt.

In einer weiteren vorteilhaften Ausführungsform kann der Filter ein als FIFO-Speicher ausgebildetes Verzögerungsglied aufweisen. Dies erleichtert die Parametrisierung und erlaubt die Verwendung eines konstanten Parameters für die Verzögerung. Aufgrund der Periodizität der Störung kann eine Kompensation der Systemverzögerung der Regelstrecke in die Stellgröße rückgeführt werden.

In vorteilhafter Weise entspricht die Prüfstandsanordnung einer überkritischen Anordnung.

Die gegenständliche Erfindung wird nachfolgend unter Bezugnahme auf die Figuren 1 bis 4 näher erläutert, die beispielhaft, schematisch und nicht einschränkend vorteilhafte Ausgestaltungen der Erfindung zeigen. Dabei zeigt
Fig.1 eine schematische Darstellung einer Prüfstandsanordnung,
Fig. 2 eine schematische Darstellung eines mathematischen Modells eines Zweimassenschwingers,
Fig. 3 ein Blockschaltbild einer beispielhaften Reglerstruktur gemäß der Erfindung und
Fig. 4 ein Blockschaltbild einer aktiven Bedämpfung gemäß der Erfindung.

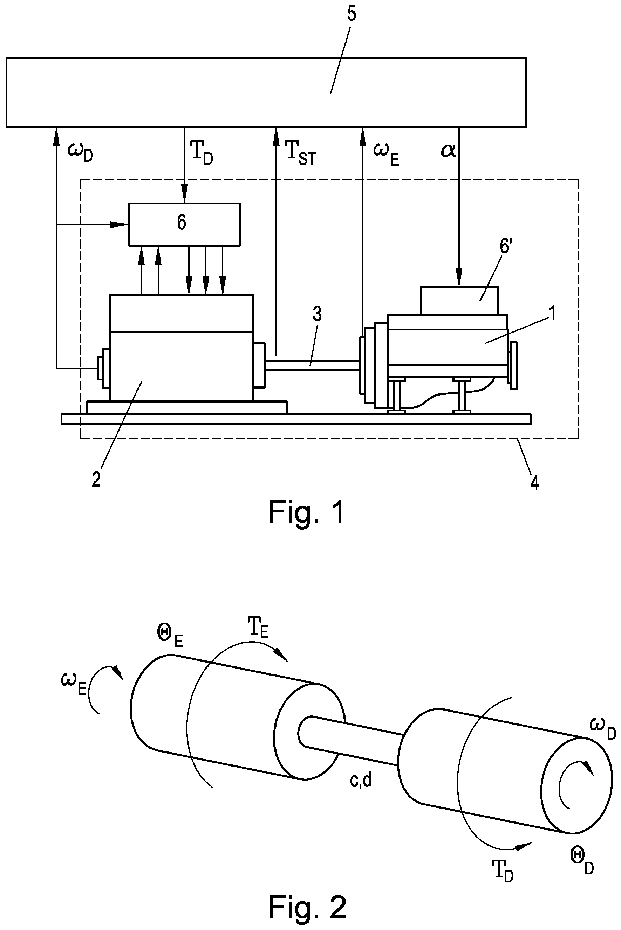

Fig. 1 zeigt in einer schematisierten Darstellung die wesentlichen Komponenten in einem Prüfstand. Ein Prüfling 1, beispielsweise ein Verbrennungsmotor, ist über eine Verbindungswelle 3 mit einer Belastungsmaschine 2 verbunden, die gemäß eines Prüflaufs den Prüfling mit einem Lastmoment beaufschlagt. Die Einheit aus Prüfling1, Belastungsmaschine 2 und Verbindungswelle 3 wird im Zusammenhang mit der gegenständlichen Beschreibung auch als Prüfstandsanordnung 4 bezeichnet.

Ein Automatisierungssystem 5 ermittelt Steuergrößen und gibt dieser der Prüfstandsanordnung 4 vor, beispielsweise eine Steuergröße für das Belastungsmaschinen-Drehmoment T_{D} der Belastungsmaschine 2 und eine Steuergröße für die Pedalstellung α des Prüflings 1. Die Steuergrößen werden von einer Stelleinrichtung 6 der Belastungsmaschine 2 bzw. einer Stelleinrichtung 6' des Prüflings 2 in die entsprechenden Stellgrößen umgewandelt.

Die Ist-Werte der Regelgrößen werden von dem Automatisierungssystem 5 über entsprechende Sensoren ermittelt, beispielsweise die in Fig. 1 dargestellten Ist-Werte für die Prüflingswinkelgeschwindigkeit ω_{E}, die Belastungsmaschinen-Winkel-Geschwindigkeit ω_{D}, und das Wellendrehmoment T_{ST}.

Das Schwingungsverhalten der Prüfstandsanordnung 4 kann mathematisch als Zweimassenschwinger modelliert werden, wie er in Fig. 2 dargestellt ist. Neben den oben definierten Werten für das Wellendrehmoment T_{ST}, das Belastungsmaschinen-Drehmoment T_{D}, das Prüflings-Drehmoment T_{E}, die Belastungsmaschinen-Winkelgeschwindigkeit ω_{D} und die Prüflingswinkelgeschwindigkeit ω_{E} beinhaltet das Modell noch die Wellensteifigkeit c, die Wellendämpfung d, das Prüflings-Trägheitsmoment θ_{E} und das Belastungsmaschinen-Trägheitsmoment θ_{D}, anhand derer Eigenfrequenzen des Systems und die Dämpfung mathematische ermittelt werden.

Für eine Prüfstandsanordnung 4 lässt sich üblicherweise durch die Modellierung als Zweimassenschwinger eine eindeutige Eigenfrequenz f₀ ermitteln. Die Dimensionierung der Verbindungswelle 3 wird üblicher Weise so gewählt, dass diese Eigenfrequenz unter der Zündfrequenz des Arbeitsbereiches eines Prüflings 1 zu liegen kommt. Die Eigenfrequenz liegt dabei im Bereich zwischen der Geschwindigkeit des Starters und der Leerlaufgeschwindigkeit des Prüflings und wird somit vom Prüfstand 4 nur kurz beim Starten des Prüflings 1 durchlaufen. Solch eine Anordnung wird als "überkritische Anordnung" bezeichnet.

Als Beispiel kann etwa ein 4-Zylinder Motor mit einem Arbeitsbereich von 600 bis 6000 rpm betrachtet werden. Bei 600 rpm ergibt sich eine Zündfrequenz von 20Hz. Für eine überkritische Anordnung wird die Wellenverbindung daher so dimensioniert, dass sich für die Prüfstandsanordnung eine Eigenfrequenz von beispielsweise 15 Hz ergibt.

Im praktischen Einsatz, insbesondere bei Prüfläufen mit noch nicht getesteten Prototypen, können sich jedoch auch Störungen unterhalb der Zündfrequenz ergeben, die auch die Eigenfrequenz anregen können. Die Eigenfrequenz könnte zum Beispiel durch eine 0,5-te Ordnung (der Drehfrequenz) einer vom Prüfling generierten Störung angeregt werden.

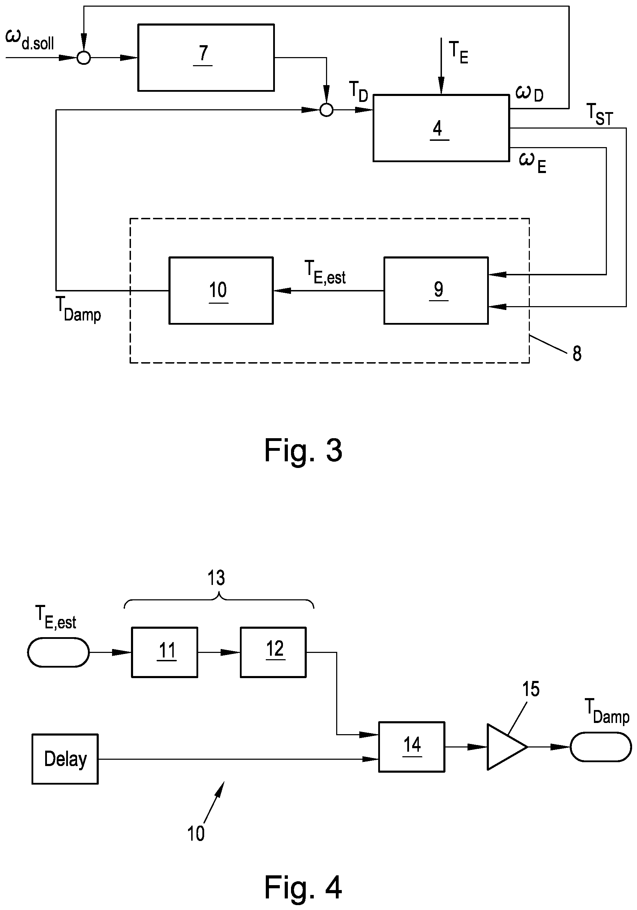

Um solche Effekte stark zu reduzieren offenbart diese Beschreibung erfindungsgemäß eine aktive Dämpfung, die im Folgenden unter Bezugnahme auf Fig. 3 beschrieben wird, wobei in Fig. 3 ein Teil der Reglerstruktur für die Belastungsmaschine schematisch dargestellt ist.

Als Eingang eines Geschwindigkeitsreglers 7 wird eine Regelabweichung als Differenz eines Sollwerts der Belastungsmaschinen-Winkelgeschwindigkeit ω_{D,Soll} und des Istwerts der Belastungsmaschinen-Winkelgeschwindigkeit ω_{D} gebildet. Der Geschwindigkeitsregler 7 erstellt auf Basis der Regelabweichung eine Steuergröße für das Belastungsmaschinen-Drehmoment T_{D}, welche an die Prüfstandsanordnung 4 (bzw. an deren in Fig. 1 dargestellte Stelleinrichtung 6) übermittelt wird. Dabei wird die Steuergröße mit einem Bedämpfungssignal T_{Damp} korrigiert, das von einer Bedämpfungseinheit 8 auf Basis des Wellendrehmoment T_{ST} und der Prüflingswinkelgeschwindigkeit ω_{E} ermittelt wird.

Die Bedämpfungseinheit 8 weist dazu eine Schätzeinheit 9 auf, die einen Schätzwert T_{E,est} für ein inneres Drehmoment T_{E} des Prüflings 1 ermittelt. Das innere Drehmoment T_{E} des Prüflings ist am Prüfstand nicht direkt messbar und kann somit als nicht messbare Störgröße des Regelkreises betrachtet werden. Diese Größe ist aber eine essentielle Größe als Regelungseingangsgröße für die aktive Dämpfung, da sie die Anregung für das Zweimassenschwinger-System enthält.

Um den Schätzwert T_{E,est} für das innere Drehmoment T_{E} zu erstellen, kann die Schätzeinheit 9 einen Kalman-Filter aufweisen, der für den entsprechenden Frequenzbereich optimiert ist und den Schätzwert T_{E,est} auf Basis des Wellendrehmoments T_{ST} und der Prüflingswinkelgeschwindigkeit ω_{E} ermittelt. Eine Filtereinheit 10 wandelt dann den von der Schätzeinheit 9 erhaltenen Schätzwert T_{E,est} in das Bedämpfungssignal T_{Damp} um.

Die Filtereinheit 10 ist in Fig. 4 detaillierter schematisch dargestellt. In der Filtereinheit 10 wird zuerst das Signal des Schätzwerts T_{E,est} mittels eines Hochpassfilters 11 vom Gleichanteil befreit. Der nachfolgende Tiefpassfilter 12 ist optional und wird nur benötigt, wenn die höheren Wechselanteile in der Stellgröße für die Belastungsmaschine 2 die Grenzwerte für die Belastungsmaschine 2 überschreiten. Der Hochpassfilter 11 und der Tiefpassfilter 12 können somit als Bandpassfilter 13 angesehen werden, der aus dem Signal des Schätzwerts T_{E,est} einen Bandbereich mit der zu dämpfende Eigenfrequenz herausfiltert.

Um die Totzeiten auszugleichen wird auf das Signal dann in einem Verzögerungsglied 14 eine Verzögerung (Delay) angewendet und das Signal wird in einem Verstärker 15 verstärkt, um das Bedämpfungssignal T_{Damp} in einer für die Dämpfung optimalen Amplitude zu erhalten.

Um die Verzögerung (die auch als Phasenverdrehung interpretiert werden kann) auf einfache Weise zu realisieren, kann das Verzögerungsglied als FIFO-Speicher mit konstanter (bzw. parametrisierbarer) Länge realisiert werden. Eine konstante Länge ist zulässig, da eine bestimmte und bekannte Frequenz (die Eigenfrequenz) gedämpft werden soll. Weiters wird angenommen, dass es sich um eine periodische Störung handelt, was auch mit Versuchsergebnissen übereinstimmt und auch in der Fachliteratur bestätigt wird.

Unter diesen Annahmen sind somit folgende Phasenfehler mit dem FIFO Speicher kompensierbar:
- Systematischer Fehler, da das Dämpfungs-Moment nicht an der Welle eingebracht wird sondern im Luftspalt der Belastungseinheit (90° Phasenfehler)
- Phasenfehler, die sich aufgrund von ungleich-null Phasengang diverser Filternetzwerke in der Regelung ergeben bzw. aufgrund von Totzeiten im Closed-Loop Regelkreis ergeben

Durch eine parametrierbare Verstärkung im Verstärker 15 kann der optimale Grad der Dämpfung eingestellt werden.

Sowohl der parametrisierbare Wert der Verstärkung, als auch die Verzögerung bzw. Phasenkompensation können in einer Simulation des Prüflaufs vorab bestimmt werden und müssen daher nicht über Trial & Error ermittelt werden.

### Bezugszeichen:

Prüfling 1
Belastungsmaschine 2
Verbindungswelle 3
Prüfstandsanordnung 4
Automatisierungssystem 5
Stelleinrichtung 6, 6'
Geschwindigkeitsregler 7
Bedämpfungseinheit 8
Schätzeinheit 9
Filter 10
Hochpassfilters 11
Tiefpassfilter 12
Bandpassfilter 13
Verzögerungsglied 14
Verstärker 15

Pedalstellung α
Belastungsmaschinen-Drehmoment T_{D}
Wellendrehmoment T_{ST}
Prüflings-Trägheitsmoment θ_{E}
Belastungsmaschinen-Winkelgeschwindigkeit ω_{D}
Prüflingswinkelgeschwindigkeit ω_{E}
Wellensteifigkeit c
Wellendämpfung d
Belastungsmaschinen-Trägheitsmoment θ_{D}
Prüflings-Trägheitsmoment θ_{E}

## Patentansprüche

1. Verfahren zur Regelung einer Prüfstandsanordnung (4) mit einem Prüfling (1) und mit einer Belastungsmaschine (2), die durch eine Verbindungswelle (3) mit dem Prüfling (1) verbunden ist, wobei die Prüfstandsanordnung (4) einer überkritischen Anordnung entspricht, **dadurch gekennzeichnet, dass** ein Schätzwert (T_{E,est}) für das innere Drehmoment (T_{E}) des Prüflings (1) ermittelt wird, wobei aus dem Schätzwert (T_{E,est}) unter Berücksichtigung einer zu dämpfenden Eigenfrequenz (f₀) der Prüfstandsanordnung (4) und einer Verzögerung (Delay) ein Bedämpfungssignal (T_{Damp}) ermittelt und im Regelkreis rückgeführt wird.

2. Verfahren nach Anspruch 1, **dadurch gekennzeichnet, dass** der Schätzwert (T_{E,est}) aus der Prüflingswinkelgeschwindigkeit (ω_{E}) und dem Wellenmoment (T_{ST}) ermittelt wird.

3. Verfahren nach Anspruch 1 oder 2, **dadurch gekennzeichnet, dass** bei der Ermittlung des Bedämpfungssignals (T_{Damp}) aus dem Schätzwert (T_{E,est}) ein die zu dämpfende Eigenfrequenz (f₀) umfassender Bandbereich herausgefiltert und das herausgefilterte Signal um eine Verzögerung (Delay) verzögert und um eine Verstärkung (Gain) verstärkt wird.

4. Verfahren nach Anspruch 3, **dadurch gekennzeichnet, dass** die Parameter für die Verzögerung (del) und/oder die Verstärkung (Gain) und/oder den Bandbereich in einer Simulation vorab bestimmt werden.

5. Verfahren nach Anspruch 3 oder 4, **dadurch gekennzeichnet, dass** die Verzögerung (Delay) ein konstanter Parameter ist.

6. Vorrichtung zur Regelung einer Prüfstandsanordnung (4) mit einem Prüfling (1) und mit einer Belastungsmaschine (2), die durch eine Verbindungswelle (3) mit dem Prüfling (1) verbunden ist, wobei die Prüfstandsanordnung (4) einer überkritischen Anordnung entspricht, **dadurch gekennzeichnet, dass** die Vorrichtung eine Bedämpfungseinheit (8) mit einer Schätzeinheit (9) und einem Filter (10) aufweist, wobei die Schätzeinheit (9) einen Schätzwert (T_{E,est}) für das innere Drehmoment (T_{E}) des Prüflings (1) erstellt und wobei der Filter aus dem Schätzwert (T_{E,est}) auf Basis einer zu dämpfenden Eigenfrequenz (f₀) der Prüfstandsanordnung (4) und einer Verzögerung (Delay) ein Bedämpfungssignal (T_{Damp}) erstellt und im Regelkreis rückführt.

7. Vorrichtung nach Anspruch 6, **dadurch gekennzeichnet, dass** die Schätzeinheit (9) den Schätzwert (T_{E,est}) aus der Prüflingswinkelgeschwindigkeit (ω_{E}) und dem Wellenmoment (T_{ST}) ermittelt.

8. Vorrichtung nach Anspruch 6 oder 7, **dadurch gekennzeichnet, dass** die Schätzeinheit (9) einen Kalman-Filter aufweist.

9. Vorrichtung nach einem der Ansprüche 6 bis 8, **dadurch gekennzeichnet, dass** der Filter (10) ein als FIFO-Speicher ausgebildetes Verzögerungsglied (14) aufweist.

## Claims

1. Method for controlling a test stand arrangement (4) comprising a test specimen (1) and comprising a loading machine (2) which is connected to the test specimen (1) by a connecting shaft (3), wherein the test stand arrangement (4) corresponds to a supercritical arrangement, **characterized in that** an estimated value (T_{E,est}) is determined for the internal torque (T_{E}) of the test specimen (1), a damping signal (T_{Damp}) being determined from the estimated value (T_{E,est}), while taking into account a natural frequency (f₀) to be damped and a delay (Delay), and said damping signal being fed back into the control loop.

2. Method according to claim 1, **characterized in that** the estimated value (T_{E,est}) is determined from the test specimen angular velocity (ω_{E}) and the shaft torque (T_{ST}).

3. Method according to either claim 1 or claim 2, **characterized in that**, when determining the damping signal (T_{Damp}) from the estimated value (T_{E,est}), a band range comprising the natural frequency (f₀) to be damped is filtered out and the filtered signal is delayed by a delay (Delay) and amplified by an amplification (Gain).

4. Method according to claim 3, **characterized in that** the parameters for the delay (del) and/or the amplification (Gain) and/or the band range are determined in advance in a simulation.

5. Method according to either claim 3 or claim 4, **characterized in that** the delay (Delay) is a constant parameter.

6. Device for controlling a test stand arrangement (4) comprising a test specimen (1) and comprising a loading machine (2) which is connected to the test specimen (1) by a connecting shaft (3), wherein the test stand arrangement (4) corresponds to a supercritical arrangement, **characterized in that** the device has a damping unit (8) comprising an estimating unit (9) and a filter (10), the estimating unit (9) establishing an estimated value (T_{E,est}) for the internal torque (T_{E}) of the test specimen (1) and the filter establishing a damping signal (T_{Damp}) from the estimated value (T_{E,est}) on the basis of a natural frequency (f₀) to be damped and a delay (Delay) and feeding said damping signal back into the control loop.

7. Device according to claim 6, **characterized in that** the estimating unit (9) determines the estimated value (T_{E,est}) from the test specimen angular velocity (ω_{E}) and the shaft torque (T_{ST}).

8. Device according to either claim 6 or claim 7, **characterized in that** the estimating unit (9) comprises a Kalman filter.

9. Device according to any of claims 6 to 8, **characterized in that** the filter (10) comprises a delay element (14) designed as a FIFO memory.

## Revendications

1. Procédé de régulation d'un ensemble banc d'essai (4) comportant une pièce d'essai (1) et une machine de charge (2) qui est reliée à la pièce en essai (1) par un arbre de transmission (3), l'ensemble banc d'essai (4) correspondant à un ensemble supercritique, **caractérisé en ce qu'**une valeur estimée (T_{E,est}) est déterminée pour le couple interne (T_{E}) de la pièce d'essai (1), un signal d'amortissement (T_{Damp}) est déterminé à partir de la valeur estimée (T_{E,est}), en tenant compte d'une fréquence propre (f₀) de l'ensemble banc d'essai (4) à amortir et d'un retard (Delay), et est renvoyé dans le circuit de régulation.

2. Procédé selon la revendication 1, **caractérisé en ce que** la valeur estimée (T_{E,est}) est déterminée à partir de la vitesse angulaire (ω_{E}) de la pièce d'essai et du couple d'arbre (T_{ST}).

3. Procédé selon la revendication 1 ou 2, **caractérisé en ce que**, lors de la détermination du signal d'amortissement (T_{Damp}) à partir de la valeur estimée (T_{E,est}), une gamme de bande comprenant la fréquence propre (f₀) à amortir est filtrée et le signal filtré est retardé d'un retard (Delay) et amplifié par une amplification (Gain).

4. Procédé selon la revendication 3, **caractérisé en ce que** les paramètres du retard (del) et/ou de l'amplification (Gain) et/ou la gamme de bande sont déterminés à l'avance dans une simulation.

5. Procédé selon la revendication 3 ou 4, **caractérisé en ce que** le retard (Delay) est un paramètre constant.

6. Dispositif de régulation d'un ensemble banc d'essai (4) comportant une pièce d'essai (1) et une machine de charge (2) qui est reliée à la pièce d'essai (1) par un arbre de transmission (3), l'ensemble banc d'essai (4) correspondant à un ensemble supercritique, **caractérisé en ce que** le dispositif comporte une unité d'amortissement (8) dotée d'une unité d'estimation (9) et d'un filtre (10), l'unité d'estimation (9) produisant une valeur estimée (T_{E,est}) pour le couple interne (T_{E}) de la pièce d'essai (1), et le filtre produisant un signal d'amortissement (T_{Damp}) à partir de la valeur estimée (T_{E,est}) sur la base d'une fréquence propre (f₀) de l'ensemble banc d'essai (4) à amortir et d'un retard (Delay), et renvoyant ledit signal d'amortissement dans le circuit de régulation.

7. Dispositif selon la revendication 6, **caractérisé en ce que** l'unité d'estimation (9) détermine la valeur estimée (T_{E,est}) à partir de la vitesse angulaire (ω_{E}) de la pièce d'essai et du couple d'arbre (T_{ST}).

8. Dispositif selon la revendication 6 ou 7, **caractérisé en ce que** l'unité d'estimation (9) comporte un filtre de Kalman.

9. Dispositif selon l'une des revendications 6 à 8, **caractérisé en ce que** le filtre (10) comporte un élément à retard (14) réalisé sous la forme d'une mémoire FIFO.
